# FASCICULE DE BREVET EUROPEEN

(11) **EP 3 567 592 B1**
(45) Date de publication et mention de la délivrance du brevet: **02.11.2022**
(21) Numéro de dépôt: 19173436.7
(22) Date de dépôt: 09.05.2019
(51) Int. Cl.: G11C 13/00

(54) **PROCÉDÉ DE PROGRAMMATION D'UNE MÉMOIRE VIVE RÉSISTIVE**
PROGRAMMIERVERFAHREN EINES RESISTIVEN ARBEITSSPEICHERS
METHOD FOR PROGRAMMING A RESISTIVE RANDOM ACCESS MEMORY

(30) Priorité: 11.05.2018 FR 1853997
(43) Date de publication de la demande: 13.11.2019
(73) Titulaire: Commissariat à l'Energie Atomique et aux Energies Alternatives, 75015 Paris (FR)
(72) Inventeur: SASSINE, Gilbert, 38054 GRENOBLE CEDEX 09 (FR); MOLAS, Gabriel, 38054 GRENOBLE CEDEX 09 (FR)
(74) Mandataire: Cabinet Camus Lebkiri

(56) Documents cités:
- SASSINE GILBERT ET AL: "Sub-pJ consumption and short latency time in RRAM arrays for high endurance applications", 2018 IEEE INTERNATIONAL RELIABILITY PHYSICS SYMPOSIUM (IRPS), IEEE, 11 mars 2018 (2018-03-11), XP033337490, DOI: 10.1109/IRPS.2018.8353675 [extrait le 2018-05-02]
- YIN M ET AL: "Improvement of Resistive Switching in Using New RESET Mode", IEEE ELECTRON DEVICE LETTERS, IEEE SERVICE CENTER, NEW YORK, NY, US, vol. 29, no. 7, 9 juillet 2008 (2008-07-09), pages 681-683, XP011229619, ISSN: 0741-3106, DOI: 10.1109/LED.2008.923319

## Description

### DOMAINE TECHNIQUE

La présente invention est relative au domaine des mémoires non-volatiles à résistance variable, appelées également mémoires vives résistives ou RRAM (pour « Resistive Random-Access Memories » en anglais). L'invention concerne plus particulièrement un procédé de programmation d'une mémoire vive résistive.

### ÉTAT DE LA TECHNIQUE

Les mémoires vives résistives (RRAM) sont aujourd'hui le sujet d'une grande attention, en raison notamment de leur faible consommation électrique, leur densité élevée et leur grande endurance. Plusieurs technologies de mémoires résistives sont en cours de développement avec des degrés de maturité divers. On peut citer notamment les mémoires à changement de phase PCRAM (« Phase-Change Random-Access Memory »), les mémoires à pont conducteur CBRAM (« Conductive-Bridging Random-Access Memory ») et les mémoires à base d'oxyde OxRAM (« Oxyde-based Random-Access Memory »).

Une mémoire résistive comporte une multitude de cellules mémoire agencées en lignes et colonnes, sous la forme d'une matrice. En fonction de sa taille, la matrice de cellules mémoire peut être divisée en blocs, chaque bloc comprenant par exemple 4 096 cellules mémoire.

Chaque cellule mémoire comporte une couche de matériau diélectrique disposée entre deux électrodes. Le matériau diélectrique est capable de basculer de manière réversible entre un état fortement résistif et un état faiblement résistif, appelés respectivement « HRS » (pour « High-Resistance State » en anglais) et « LRS » (« Low-Resistance State »). Ces deux états de résistance permettent de stocker un bit d'information dans chaque cellule mémoire.

Le mécanisme à l'origine de la variation de résistance de la cellule mémoire dépend de la technologie utilisée. Dans les PCRAM par exemple, il s'agit de matériaux semiconducteurs chalcogénures que l'on peut faire transiter d'un état amorphe (fortement résistif) à un état cristallin (faiblement résistif), ou inversement, par des impulsions de tension d'amplitude et durée appropriées. Dans les CBRAM, des filaments conducteurs sont formés ou détruits en faisant diffuser des ions métalliques (par exemple Ag⁺) dans une matrice semi-conductrice (par exemple Ge). Enfin, les OxRAM ont un comportement similaire à celui des CBRAM dans le sens où un chemin conducteur se forme entre les électrodes. Ce chemin conducteur semble être dû à l'accumulation de lacunes d'oxygène au sein de la couche d'oxyde (au moins pour la famille des oxydes à base de métaux de transition), plutôt qu'à l'accumulation d'ions métalliques. Toutes ces formes de mémoire impliquent le passage d'un courant électrique à travers la cellule mémoire, laquelle présente une résistance électrique variant entre une première valeur élevée et une deuxième valeur plus faible. Programmer une cellule mémoire résistive consiste à la faire passer de l'état fortement résistif (HRS) à l'état faiblement résistif (LRS), ou inversement. L'opération de programmation permettant de passer de l'état HRS à l'état LRS est appelée écriture ou « set », tandis que l'opération de programmation permettant de passer de l'état LRS à l'état HRS est appelé effacement ou « reset ». La cellule mémoire est programmée en appliquant entre ses électrodes une tension de programmation (positive ou négative selon qu'il s'agisse d'une écriture ou d'un effacement).

Les cellules mémoire de la matrice sont généralement programmées (i.e. écrites ou effacées) de façon collective, par exemple par blocs. Toutes les cellules mémoire de la matrice peuvent être également programmées simultanément. Les documents de l'état de la technique SASSINE G ET AL: "Sub-pJ consumption and short latency time in RRAM arrays for high endurance applications", 2018 IEEE INTERNATIONAL RELIABILITY PHYSICS SYMPOSIUM (IRPS), 11 mars 2018 et YIN M ET AL: "Improvement of Resistive Switching in Using New RESET Mode", IEEE ELECTRON DEVICE LETTERS, vol.29, no.7, 9 juillet 2008 divulguent des procédés de programmation de mémoires vives résistives.

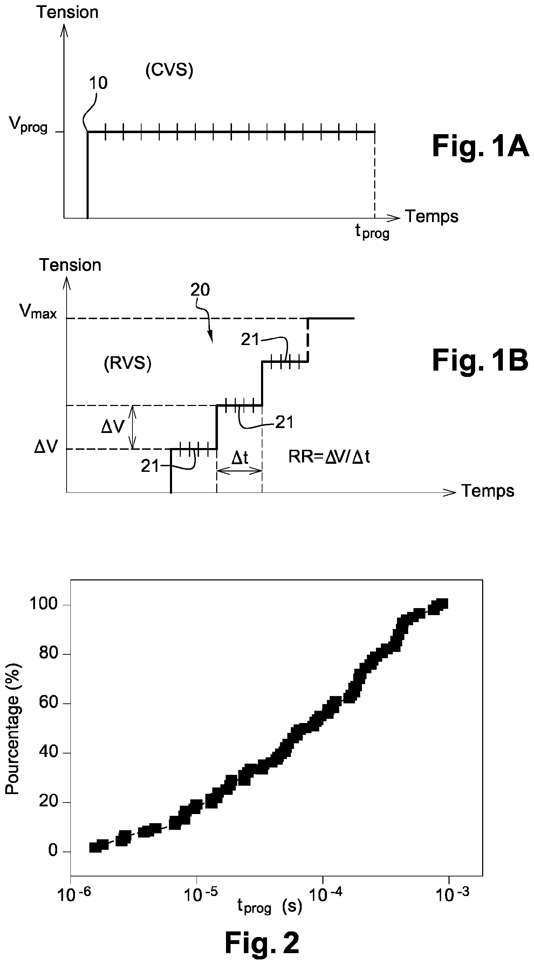

Il existe deux principaux schémas de programmation d'une cellule de mémoire résistive : la méthode dite « CVS » du stress en tension constante (« Constant Voltage Stress » en anglais) et la méthode dite « RVS » du stress en rampe de tension (« Ramp Voltage Stress »). Les méthodes CVS et RVS, représentées respectivement par les figures 1A et 1B, sont à l'origine des techniques de caractérisation utilisées pour étudier la fiabilité des oxydes dans les structures MOS (Métal-Oxyde-Semiconducteur). Elles permettent respectivement de mesurer le temps et la tension de claquage de l'oxyde. Ces deux méthodes ont été décrites et comparées dans les articles «

Rapid Prediction of RRAM RESET-State Disturb by Ramped Voltage Stress », W. C. Luo et al., IEEE Electron Device Letters, Vol. 33, No. 4, pp. 597-599, 2012 et «

Reliability screening of high-k dielectrics based on voltage ramp stress », A. Kerber et al., Microelectronics Reliability, Vol. 47, No. 4-5, pp. 513-517, 2007. La méthode CVS (cf. Fig.1A) consiste à appliquer à la cellule mémoire une impulsion 10 de tension constante V_{prog} jusqu'à l'obtention d'un niveau de courant prédéterminé. Le courant électrique circulant à travers la cellule mémoire est mesuré à intervalles réguliers au cours de l'impulsion de tension 10. Une fois le niveau de courant atteint, l'impulsion de tension 10 est arrêtée.

Cette méthode permet de tracer l'évolution du courant électrique en fonction de la durée de l'impulsion 10 et d'extraire le temps de programmation t_{prog} de la cellule mémoire. Par exemple, l'écriture d'une cellule mémoire se traduit par une augmentation brusque du courant électrique, car la cellule mémoire passe de l'état fortement résistif à l'état faiblement résistif. Le temps de programmation t_{prog} de la cellule mémoire (dans l'état faiblement résistif) est la durée à laquelle se produit l'augmentation brusque de courant.

Le principal inconvénient de la méthode CVS est la grande dispersion des temps de programmation t_{prog} des cellules mémoire au sein d'une même matrice. La figure 2 montre la distribution cumulée des temps de programmation t_{prog} de 100 cellules mémoire OxRAM (Ni/HfO₂/p⁺-Si) programmées dans l'état LRS par la méthode CVS. La tension de programmation V_{prog} appliquée à ces cellules mémoire est de 1 V.

On constate grâce à cette figure que le temps de programmation t_{prog} varie, pour 100 cellules mémoire appartenant à une même matrice, de 1 µs à 1 ms environ. Il faut donc appliquer une impulsion de tension d'une durée au moins égale à 1 ms si l'on souhaite programmer toutes ces cellules en une seule fois. La méthode CVS est donc particulièrement lente pour programmer tout ou partie d'une matrice de cellules mémoire. Avec cette méthode, les cellules mémoire subissent en outre un stress électrique pendant toute la durée de l'impulsion, quelle que soit leur durée de programmation effective, ce qui nuit à la fiabilité de la mémoire vive résistive.

La méthode RVS (Fig.1 B) consiste à appliquer à la cellule mémoire à programmer une rampe de tension 20, en forme d'escalier. Cette rampe 20 comporte des paliers de tension 21 successifs, c'est-à-dire des périodes où la tension appliquée est constante, afin de pouvoir mesurer le courant qui traverse la cellule mémoire. La rampe de tension 20 prend fin lorsqu'un niveau de courant prédéterminé est atteint. Le premier palier 21 se situe à une tension égale au pas ΔV entre deux paliers de tension successifs. La vitesse de rampe RR est définie comme le rapport entre le pas de tension ΔV et la durée Δt des paliers de tension 21. La méthode RVS permet de tracer une caractéristique courant-tension (I-V) de la cellule mémoire, d'où l'on peut extraire sa tension de programmation V_{prog}.

Comme démontré dans les articles susmentionnés, la méthode de programmation RVS réduit la dispersion des temps de programmation par rapport à la méthode CVS. Le temps requis pour programmer un groupe de cellules mémoire reste malgré tout élevé.

### RÉSUMÉ DE L'INVENTION

L'invention vise à réduire le temps nécessaire pour programmer une pluralité de cellules mémoire appartenant à une mémoire vive résistive et à réduire le stress électrique subi par ces cellules mémoire lors de leur programmation, d'afin d'améliorer respectivement la vitesse de programmation et la fiabilité de la mémoire vive résistive.

Un premier aspect de l'invention concerne un procédé de programmation d'une mémoire vive résistive selon la revendication indépendante 1, la mémoire vive résistive comportant une matrice de cellules mémoire. Ce procédé comprend une étape de programmation consistant à appliquer une rampe de tension de programmation aux cellules mémoire d'une partie au moins de la matrice, la rampe de tension de programmation démarrant à une première valeur de tension non-nulle, dite tension de départ, et prenant fin à une deuxième valeur de tension, dite tension d'arrivée, supérieure en valeur absolue à la première valeur de tension. Le procédé est remarquable en ce que la tension d'arrivée est déterminée de sorte que chaque cellule mémoire de ladite au moins une partie de la matrice présente une première probabilité comprise entre 1/(10N) et 1/N d'avoir une tension de programmation supérieure en valeur absolue à la tension d'arrivée, N étant le nombre de cellules mémoire dans ladite au moins une partie de la matrice.

Autrement dit, en acceptant qu'au maximum une cellule mémoire (statistiquement) ne soit pas programmée à la fin de la rampe de programmation, la tension d'arrivée peut être fixée à une valeur proche de la tension de programmation de la cellule mémoire la plus lente de la partie de la matrice. A l'inverse, dans la méthode de programmation RVS de l'art antérieur, la tension d'arrivée est choisie excessivement élevée, afin de s'assurer que toutes les cellules mémoire soient effectivement programmées. La tension d'arrivée de la rampe de programmation utilisée dans le procédé selon l'invention est donc plus faible que celle utilisée dans la méthode de l'art antérieur, ce qui a pour effet de réduire le temps de programmation et le stress électrique subi par les cellules mémoire.

Dans un mode de mise en oeuvre préférentiel du procédé selon l'invention, la tension de départ est déterminée de sorte que chaque cellule mémoire de ladite au moins une partie de la matrice présente une deuxième probabilité comprise entre 1/(10N) et 1/N d'avoir une tension de programmation inférieure en valeur absolue à la tension de départ.

Alors que la tension de départ de la rampe de programmation est fixée à une valeur très faible dans la méthode RVS de l'art antérieur, typiquement à un pas de tension ΔV de la rampe, la tension de départ est ici fixée à une valeur proche de la tension de programmation de la cellule mémoire la plus rapide, car on s'autorise qu'une cellule mémoire (statistiquement) soit programmée à une valeur de tension (la tension de départ) supérieure à la véritable tension de programmation de la cellule mémoire. Un temps de programmation superflu et un stress inutile des cellules mémoire peuvent ainsi être évités. En effet, dans la méthode RVS de l'art antérieur, la première partie de la rampe de tension, depuis le premier pallier de tension jusqu'à la tension de programmation de la cellule mémoire la plus rapide à programmer, ne contribue quasiment pas à la programmation des cellules mémoire.

Selon un développement de ce mode de mise en oeuvre préférentiel, le procédé comprend initialement une étape d'étalonnage pour déterminer la tension de départ et la tension d'arrivée de la rampe de tension de programmation, connaissant le nombre N de cellules mémoire dans ladite au moins une partie de la matrice, ladite étape d'étalonnage comprenant les opérations suivantes :
- fournir une pluralité de cellules mémoire de référence identiques aux cellules mémoire de la matrice ;
- mesurer, pour chaque cellule mémoire de référence, une valeur de tension à laquelle ladite cellule mémoire de référence est programmée ;
- établir une loi de distribution à partir des valeurs de la tension de programmation des cellules mémoire de référence ; et
- déterminer, à l'aide de la loi de distribution, la tension d'arrivée correspondant à la première probabilité et la tension de départ correspondant à la deuxième probabilité.

La valeur de la tension de programmation de chaque cellule mémoire de référence est de préférence mesurée en appliquant à ladite cellule mémoire de référence une rampe de tension de caractérisation, la rampe de tension de caractérisation comportant des paliers de tension successifs, et en mesurant lors des paliers de tension successifs le courant traversant ladite cellule mémoire.

Le procédé selon l'invention peut également présenter une ou plusieurs des caractéristiques ci-dessous, considérées individuellement ou selon toutes les combinaisons techniquement possibles :
- la tension d'arrivée et/ou la tension de départ est déterminée à partir d'une distribution de tensions de programmation d'un échantillon de cellules mémoire, ladite distribution obéissant à une loi normale ;
- la première probabilité et la deuxième probabilité sont de préférence égales, avantageusement égales à 1/N ; et
- la rampe de tension de programmation comporte des paliers de tension successifs.

Un deuxième aspect de l'invention concerne un procédé de programmation d'une mémoire vive selon la revendication indépendante 9.

Un troisième aspect de l'invention concerne un dispositif électronique selon la revendication indépendante 10.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- les figures 1A et 1B, précédemment décrites, représentent deux méthodes de programmation de cellule mémoire résistive selon l'art antérieur ;
- la figure 2, précédemment décrite, représente la distribution des temps de programmation d'une pluralité de cellules mémoire OxRAM programmées selon la méthode de la figure 1A ;
- la figure 3 représente des caractéristiques courant-tension d'une pluralité de cellules mémoire OxRAM programmées selon la méthode de la figure 1B ;
- la figure 4 montre une rampe de tension appliquée à des cellules de mémoire vive résistive, au cours d'un procédé de programmation selon un mode de mise en oeuvre préférentiel de l'invention ;
- la figure 5 représente un exemple de mise en oeuvre d'une étape préliminaire du procédé de programmation selon l'invention, afin de déterminer la tension de départ et la tension d'arrivée de la rampe de la figure 4 ;
- la figure 6 représente la distribution des temps de programmation d'une pluralité de cellules mémoire OxRAM programmées suivant le procédé de l'invention et suivant la méthode de la figure 1A ; et
- la figure 7 représente la distribution des résistances à l'état LRS et à l'état HRS de deux cellules mémoire OxRAM programmées suivant le procédé de l'invention et suivant la méthode de la figure 1B.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

Dans la description qui suit, on appelle « programmation » l'opération consistant à faire basculer une cellule de mémoire vive résistive (RRAM) de manière réversible entre un état fortement résistif appelé « HRS » et un état faiblement résistif appelé « LRS ». Lorsque la cellule mémoire résistive passe de l'état HRS à l'état LRS, l'opération de programmation correspondante est appelée écriture ou « set ». Inversement, lorsque la cellule mémoire résistive passe de l'état LRS à l'état HRS, l'opération de programmation correspondante est appelée effacement ou « reset ». Une opération de programmation peut donc être soit une opération d'écriture, soit une opération d'effacement.

La cellule mémoire résistive présente dans l'état HRS une valeur de résistance électrique R_{HRS} supérieure à un premier seuil de résistance et dans l'état LRS une valeur de résistance électrique R_{LRS} inférieure à un deuxième seuil de résistance. Le deuxième seuil de résistance est inférieur au premier seuil de résistance. La différence entre les premier et deuxième seuils de résistance est communément appelée « fenêtre de programmation » de la cellule mémoire.

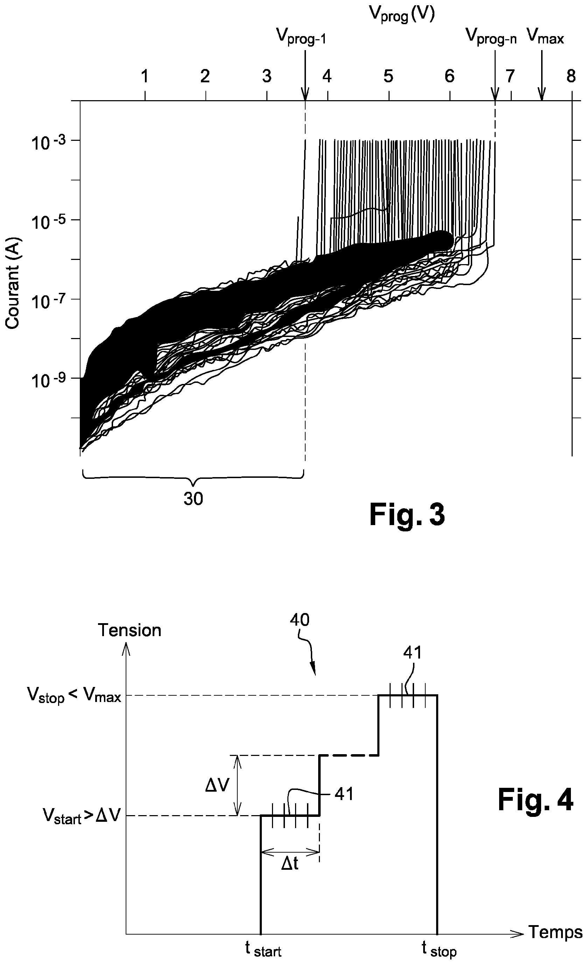

La figure 3 montre à titre d'exemple les caractéristiques courant-tension (I-V) d'un groupe de cellules mémoire programmées dans l'état LRS par la méthode RVS de la figure 1B. Ces cellules mémoire sont de type OxRAM (« Oxyde-based Random-Access Memory ») et comprennent successivement une électrode supérieure en nickel, une couche diélectrique en oxyde de hafnium et une électrode inférieure en silicium dopé (i.e. empilement de type Ni/HfO₂/p⁺-Si). La rampe de tension qui a été appliquée à ces cellules mémoire démarre à une tension de 0,1 V et augmente par paliers de 100 mV à une vitesse constante de 1.9 MV.s⁻¹ jusqu'à une tension maximale Vₘₐₓ, par exemple de 7,5 V.

Comme indiqué précédemment, le passage de l'état HRS à l'état LRS (écriture) d'une cellule mémoire résistive se traduit sur sa caractéristique I-V par une brusque augmentation du courant électrique. Pour éviter une augmentation trop importante de la température et une destruction des cellules mémoire, un courant de limitation (« compliance current » en anglais) a été fixé à 1 mA.

Dans cet exemple, la cellule mémoire la plus rapide du groupe est programmée à une première tension V_{prog_1} d'environ 3,5 V et la cellule mémoire la plus lente du groupe est programmée à une tension finale V_{prog}_ₙ d'environ 6,8 V.

La portion 30 de la caractéristique I-V qui précède la brusque augmentation du courant ne contribue pas à la programmation de la cellule mémoire et représente donc une perte de temps et d'énergie. Autrement dit, la partie de la rampe de tension comprise entre le premier palier de tension à 0,1 V et la première tension de programmation V_{prog_1} (ici de 3,5 V) représente un stress électrique inutile pour les cellules mémoire et le temps que met la rampe de tension pour atteindre cette première tension de programmation V_{prog1} est un temps de programmation superflu.

De façon analogue, on remarque sur la figure 3 qu'un écart de tension important sépare la tension de programmation (V_{prog_n} = 6,8 V) de la dernière cellule mémoire (i.e. la plus lente à programmer) et la tension maximale de la rampe de programmation (7,5 V). Cet écart de tension représente également une perte de temps et un stress électrique inutile, car toutes les cellules ont déjà été programmées.

Partant de ces observations, les inventeurs ont développé un nouveau procédé de programmation de mémoire vive résistive. Ce procédé de programmation s'applique à tout type de mémoire vive résistive dont les cellules peuvent être programmées collectivement en leur appliquant une tension. La mémoire vive résistive est par exemple une mémoire à changement de phase PCRAM (« Phase-Change Random-Access Memory »), une mémoire à pont conducteur CBRAM (« Conductive-Bridging Random-Access Memory ») ou une mémoire à base d'oxyde OxRAM (« Oxyde-based Random-Access Memory »). De façon classique, la mémoire vive résistive comporte une pluralité de cellules mémoire disposées en lignes en en colonnes, sous la forme d'une matrice. Chaque cellule mémoire comporte une première électrode, une deuxième électrode et une couche d'un matériau diélectrique à résistance électrique variable disposée entre les première et deuxième électrodes. Les électrodes et la couche de matériau diélectrique sont généralement empilées les unes sur les autres. On parlera donc également ci-après d'électrode supérieure et d'électrode inférieure.

La figure 4 illustre schématiquement un mode de mise en oeuvre préférentiel du procédé de programmation selon l'invention.

Le procédé de programmation comporte une étape de programmation consistant à appliquer à plusieurs cellules mémoire de la matrice une même rampe de tension 40. La rampe de tension 40 peut être appliquée à l'ensemble des cellules mémoire de la matrice ou à une partie seulement de la matrice. Dans la description qui suit, on prendra l'exemple d'un bloc de cellules mémoire. Un bloc de cellules mémoire désigne une sous-matrice de cellules mémoire, c'est-à-dire un groupe de cellules mémoire agencées en lignes et en colonnes, le nombre de lignes du bloc étant inférieur au nombre de lignes de la matrice et/ou le nombre de colonnes du bloc étant inférieur au nombre de colonnes de la matrice. Un bloc de cellules mémoire contient par exemple 4096 cellules mémoire réparties en 256 lignes et 16 colonnes.

L'étape de programmation peut être une étape d'écriture ou une étape d'effacement du bloc de cellules mémoire, en fonction du signe de la tension appliquée entre les électrodes des cellules mémoire. Typiquement, une rampe de tension positive, croissante, est appliquée entre les électrodes pour écrire la cellule mémoire (cf. Fig.4) et une rampe de tension négative, décroissante, est appliquée entre les électrodes pour effacer la cellule mémoire.

La rampe de tension 40 est de préférence en forme d'escalier, c'est-à-dire qu'elle comporte une succession de paliers de tension 41. Ces paliers de tension 41 permettent de stresser les cellules mémoire et, si besoin, de mesurer le courant qui traverse les cellules mémoire lors de la programmation. La vitesse de la rampe (égale au pas de tension ΔV entre deux paliers 41 successifs divisée par la durée ΔV des paliers 41) est choisie notamment en fonction de la vitesse de programmation recherchée. Plus cette rampe est élevée, plus le temps de programmation t_{prog} de chaque cellule mémoire est faible mais, en contrepartie, plus la tension de programmation V_{prog} est élevée. La vitesse de la rampe 40 est par exemple comprise entre 15 kV.s⁻¹ et 140 kV.s⁻¹.

La rampe de tension 40 démarre (à l'instant tₛₜₐᵣₜ) à une première valeur de tension Vₛₜₐᵣₜ non-nulle, appelée tension de départ, et prend fin (à l'instant tₛₜₒₚ) à une deuxième valeur de tension Vₛₜₒₚ, appelée tension d'arrivée. La tension d'arrivée Vₛₜₒₚ est supérieure en valeur absolue à la tension de départ V_{start.}

La tension d'arrivée Vₛₜₒₚ de la rampe 40 est déterminée à partir d'une première probabilité que chaque cellule mémoire du bloc ait une tension de programmation supérieure à la tension d'arrivée Vₛₜₒₚ de la rampe, autrement dit à partir d'une première probabilité que chaque cellule mémoire ne soit pas programmée à la tension d'arrivée Vₛₜₒₚ. Cette première probabilité est fonction de la taille du bloc de cellules mémoire à programmer, c'est-à-dire du nombre N de cellules mémoire dans le bloc. La première probabilité est choisie entre 1/(10N) et 1/N (bornes incluses), de préférence entre 1/(2N) et 1/N (bornes incluses). Avec une telle probabilité, le nombre de cellules risquant de ne pas être programmées est statistiquement de 1 au maximum. La tension d'arrivée Vₛₜₒₚ est ainsi ramenée à une valeur proche de la tension de programmation de la cellule mémoire la plus lente du bloc, plutôt que fixée à une valeur (Vₘₐₓ) excessivement élevée.

Dans le mode de mise en oeuvre préférentiel de la figure 4, la tension de départ Vₛₜₐᵣₜ de la rampe 40 est une valeur de tension non-nulle bien supérieure au pas de tension ΔV utilisée dans la méthode RVS de l'art antérieur, proche de la tension de programmation de la cellule mémoire la plus rapide du bloc. Elle est déterminée à partir d'une deuxième probabilité que chaque cellule mémoire du bloc ait une tension de programmation inférieure à la tension de départ Vₛₜₐᵣₜ de la rampe. A l'instar de la première probabilité, cette deuxième probabilité est fonction du nombre N de cellules mémoire dans le bloc. La deuxième probabilité est comprise entre 1/(10N) et 1/N (bornes incluses), de préférence entre 1/(2N) et 1/N (bornes incluses). Avec une telle probabilité, le nombre de cellules risquant d'être programmées à une valeur de tension (Vₛₜₐᵣₜ) supérieure à leur véritable tension de programmation est statistiquement de 1 au maximum.

La tension d'arrivée Vₛₜₒₚ de la rampe 40 est de préférence déterminée au cours d'une étape préliminaire dite d'étalonnage à partir d'une distribution de tensions de programmation. Cette distribution de tensions de programmation peut être établie à partir d'un échantillon de cellules mémoire. La tension de départ Vₛₜₐᵣₜ peut être aussi déterminée à partir d'une distribution de tensions de programmation si l'on cherche à optimiser le point de départ de la rampe.

Pour commencer, l'étape d'étalonnage comporte la sélection d'un nombre N_{ref} de cellules mémoire de référence. Les cellules mémoire de référence sont des cellules mémoire identiques aux cellules mémoire du bloc à programmer, c'est-à-dire de même taille et comprenant le même empilement de couches actives (électrode supérieure, matériau résistif et électrode inférieure). Les cellules mémoire de référence peuvent être choisies au sein de la mémoire vive résistive à laquelle appartient le bloc à programmer ou d'une autre mémoire résistive. Les cellules mémoire de référence peuvent être également des dispositifs unitaires et donc ne pas être agencées en lignes et en colonnes comme les cellules mémoire du bloc à programmer.

Afin d'obtenir une distribution représentative d'une matrice de cellules mémoire et des statistiques fiables, le nombre N_{ref} de cellules mémoire de référence est avantageusement supérieur ou égal à 70, de préférence supérieur à égal à 100.

L'étape d'étalonnage comporte ensuite une opération consistant à mesurer la valeur de la tension de programmation V_{prog} de chaque cellule mémoire de référence. De préférence, la technique de caractérisation RVS décrite en relation avec la figure 1B est utilisée pour mesurer la tension de programmation V_{prog} de chaque cellule mémoire de référence. Comme indiqué précédemment, cette technique consiste à appliquer à chaque cellule mémoire de référence une rampe de tension dite de caractérisation jusqu'à l'obtention d'un niveau de courant prédéterminé, par exemple égal à 1 mA. Cette rampe de tension de caractérisation comporte des paliers de tension successifs suffisamment longs pour permettre plusieurs mesures du courant électrique. La vitesse de la rampe de tension est par exemple égale à 140 kV/s. Plusieurs valeurs de tension de programmation V_{prog} sont obtenues à l'issue de cette opération de mesure.

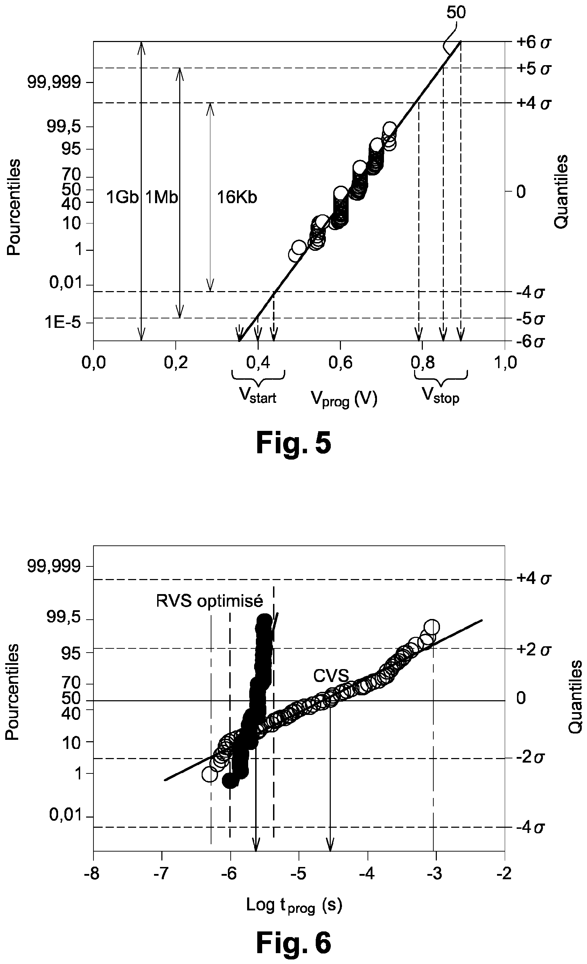

La distribution des valeurs de tension de programmation V_{prog} peut ensuite être représentée sur un graphique, par exemple du type de la figure 5, en portant en abscisses la tension de programmation V_{prog} et les quantités en ordonnées. L'échelle des ordonnées de la figure 5 est une échelle gausso-arithmétique, qui peut représenter l'effectif cumulé en pourcentages ou « pourcentiles » (à gauche sur la figure 5) ou les quantiles en nombre d'unités σ (à droite sur la figure 5, σ étant l'écart-type de la loi de distribution). La valeur médiane, obtenue à 50 % où 0 σ, correspond à la moitié des cellules mémoire de référence. Par exemple, 50 % des cellules mémoire de référence ont ici une tension de programmation inférieure à 0,6 V.

Dans l'exemple de la figure 5, le nombre de cellules mémoire de référence est égal à 100. La cellule mémoire la plus rapide est programmée à une tension de 0,5 V et la cellule mémoire la plus lente est programmée à une tension de 0,75 V. Toutes les valeurs mesurées de la tension de programmation V_{prog} sont comprises entre 0,5 V et 0,75 V. Une rampe de tension 40 démarrant à 0,5 V et se terminant à 0,75 V permettrait donc de programmer simultanément ces 100 cellules mémoire de référence.

En réalisant un ajustement statistique des valeurs de la tension de programmation V_{prog}, on constate que la tension de programmation V_{prog} obéit à une loi de distribution normale. Cette loi de distribution normale est représentée par une droite 50 (dite de Henry) sur la figure 5.

La droite 50 donne la tendance que suivent les cellules mémoire d'un type en particulier. Une fois établie, elle permet de déterminer la tension de départ Vₛₜₐᵣₜ et la tension d'arrivée Vₛₜₒₚ de la rampe de programmation 40 quelle que soit la taille du bloc (ou de matrice) à programmer, c'est-à-dire quel que soit le nombre N de cellules mémoire de ce type dans le bloc (ou la matrice), sans avoir besoin de les caractériser toutes.

En effet, à chaque taille de matrice (par exemple 16 Kb, 1 Mb, 1 Gb...) correspond des effectifs cumulés de cellules mémoire (en pourcentage) ou des quantiles (en nombre d'unités σ, soit n*σ où n est un entier naturel, positif ou négatif) qui permettent, à l'aide de la loi de distribution normale 50, de déterminer les tensions de départ Vₛₜₐᵣₜ et d'arrivée Vₛₜₒₚ correspondantes. Ces effectifs ou quantiles sont calculés à partir des première et deuxième probabilités définies plus haut.

Par exemple, dans le cas d'un bloc de 16 Kb soit 16384 cellules mémoire, on considère une première probabilité égale à 1/N pour déterminer la tension d'arrivée Vₛₜₒₚ (i.e. on tolère qu'une sur les N cellules mémoire ait une tension de programmation supérieure à Vₛₜₒₚ) et une deuxième probabilité également de 1/N pour déterminer la tension de départ Vₛₜₐᵣₜ (i.e. on tolère qu'une sur les N cellules mémoire ait une tension de programmation inférieure à Vₛₜₐᵣₜ). Le pourcentage de cellules mémoire ayant une tension de programmation supérieure à la tension d'arrivée Vₛₜₒₚ (i.e. le taux d'erreur de programmation toléré) est donc égal à 0,0061 % (1/16384*100) et le pourcentage de cellules mémoire ayant une tension de programmation inférieure à la tension de départ Vₛₜₐᵣₜ est lui aussi égal à 0,0061 %. Le pourcentage de cellules mémoire ayant une tension de programmation inférieure à Vₛₜₒₚ (i.e. le taux de programmation visé) est égal à 99,9939 % (100 % - 0,0061 %). L'intervalle de pourcentage [0,0061 %-99,9939 %] correspond à un écart autour de la valeur moyenne de ±4 σ. D'après la loi de distribution 50, la tension de départ Vₛₜₐᵣₜ correspondant à -4 σ (ou 0,0061 %) est égale à 0,45 V et la tension d'arrivée Vₛₜₒₚ correspondant à +4 σ (ou 99,9939 %) est égale à 0,8 V. Une rampe de tension 40 entre 0,45 V et 0,8 V permettra donc de programmer (rapidement et en minimisant les contraintes) le bloc de 16384 cellules mémoire (16 Kb) en une seule fois.

La figure 6 montre la distribution du temps de programmation t_{prog} obtenue avec 150 cellules OxRAM programmées dans l'état LRS grâce au procédé de l'invention (dénommé « RVS optimisé » sur la figure) et, à titre de comparaison, la distribution du temps de programmation t_{prog} obtenue avec ces mêmes cellules lorsqu'elles sont programmées (dans l'état LRS) avec la méthode CVS de l'art antérieur. Ce graphe, du même type que celui de la figure 5, représente (en ordonnée) l'effectif de cellules mémoire (exprimé en pourcentage sur l'échelle de gauche et en nombre de σ sur l'échelle de droite), en fonction du logarithme du temps de programmation t_{prog}. La distribution du temps de programmation t_{prog} présente globalement la forme d'une droite, car le temps de programmation t_{prog} obéit à une loi de distribution normale, à l'instar de la tension de programmation V_{prog} (Fig.5).

On constate grâce à cette figure que le procédé de programmation selon l'invention (méthode RVS optimisée, telle que décrite en relation avec les figures 4 et 5) permet de « resserrer » considérablement la distribution du temps de programmation t_{prog}. En effet, pour une statistique de ±2 σ (soit 95 % des cellules mémoire), la distribution s'étend sur approximativement une demi-décade dans le cas du procédé selon l'invention contre plus de 3 décades pour la méthode CVS. Par ailleurs, le temps de programmation t_{prog} à la médiane (i.e. à 50 % ou 0 σ) est amélioré d'environ un ordre de grandeur, passant de 10^{-4,5} s environ dans le cas de la méthode CVS à 10^{-5,6} s avec le procédé de programmation selon l'invention.

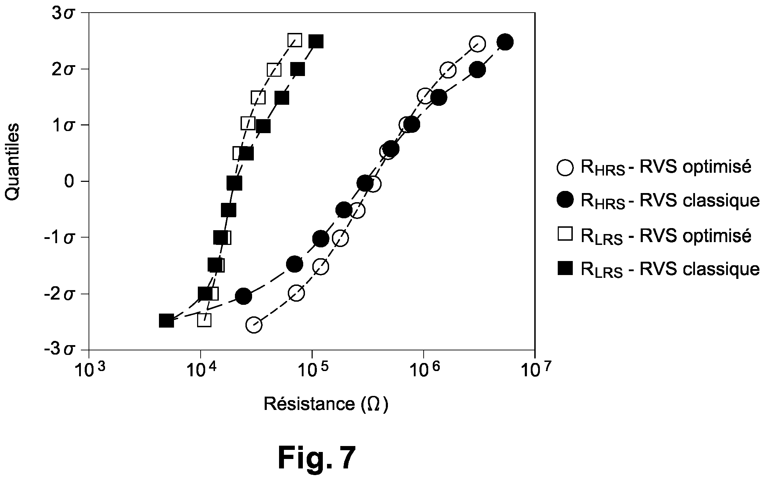

La figure 7 est un autre graphique montrant la distribution des valeurs de résistance à l'état LRS (R_{LRS}) et à l'état HRS (R_{HRS}) obtenues lors du cyclage de deux cellules mémoire OxRAM. Une cellule a été programmée suivant la méthode RVS de l'art antérieur (dénommée « RVS classique » sur la figure) et une autre cellule a été programmée suivant le procédé de l'invention (« RVS optimisé »). Le cyclage est dans cet exemple constitué d'un million de cycles d'écriture-effacement séparés d'opérations de lecture pour mesurer les valeurs de résistance. Ce graphe, du même type que ceux des figures 5 et 6, représente (en ordonnée) l'écart par rapport à la valeur moyenne des valeurs de résistance (exprimé en quantiles ou nombre de σ), en fonction des valeurs de la résistance électrique (échelle logarithmique en abscisse). Comme la résistance obéit elle aussi à une loi de distribution normale, les distributions des résistances R_{HRS} et R_{LRS} ont globalement chacune la forme d'une droite.

L'optimisation de la tension de départ Vₛₜₐᵣₜ et de la tension d'arrivée Vₛₜₒₚ a pour conséquence de redresser les distributions de résistance R_{LRS} et R_{HRS} (les droites sont plus pentues). Après 1 million de cycles de programmation suivant le procédé de l'invention, les états de résistance LRS et HRS peuvent toujours être distingués, contrairement à la situation obtenue avec la méthode RVS classique (où les queues de distribution se croisent). La fenêtre de programmation peut donc être respectée pendant un plus grand nombre de cycles. Ces distributions de résistance traduisent une amélioration de la fiabilité de la cellule mémoire, car celle-ci subit moins de stress électrique durant sa programmation grâce au procédé selon l'invention.

Pour mettre en oeuvre le procédé de programmation selon l'invention, la mémoire vive résistive pourra être équipée d'une source d'alimentation configurée pour générer une rampe de tension entre la tension de départ Vₛₜₐᵣₜ et la tension d'arrivée Vₛₜₒₚ et de moyens pour appliquer cette rampe de tension aux cellules mémoire de la matrice, tels qu'un ou plusieurs circuits d'adressage, des lignes de mot et des lignes de bits. L'étendue de la protection de la présente invention est définie par les revendications 1 à 10 annexées.

## Revendications

1. Procédé de programmation d'une mémoire vive résistive comportant une matrice de cellules mémoire, comprenant une étape de programmation consistant à appliquer une rampe de tension de programmation (40) aux cellules mémoire d'une partie au moins de la matrice, la rampe de tension de programmation démarrant à une première valeur de tension non-nulle, dite tension de départ (Vₛₜₐᵣₜ), et prenant fin à une deuxième valeur de tension, dite tension d'arrivée (Vₛₜₒₚ), supérieure en valeur absolue à la première valeur de tension,
procédé **caractérisé en ce que** la tension d'arrivée (Vₛₜₒₚ) est déterminée de sorte que chaque cellule mémoire de ladite au moins une partie de la matrice présente une première probabilité comprise entre 1/(10N) et 1/N d'avoir une tension de programmation (V_{prog}) supérieure en valeur absolue à la tension d'arrivée (Vₛₜₒₚ), N étant le nombre de cellules mémoire dans ladite au moins une partie de la matrice.

2. Procédé selon la revendication 1, dans lequel la tension d'arrivée (Vₛₜₒₚ) est déterminée à partir d'une distribution de tensions de programmation (V_{prog}) d'un échantillon de cellules mémoire, ladite distribution obéissant à une loi normale.

3. Procédé selon l'une des revendications 1 et 2, dans lequel la tension de départ (Vₛₜₐᵣₜ) est déterminée de sorte que chaque cellule mémoire de ladite au moins une partie de la matrice présente une deuxième probabilité comprise entre 1/(10N) et 1/N d'avoir une tension de programmation (V_{prog}) inférieure en valeur absolue à la tension de départ (Vₛₜₐᵣₜ).

4. Procédé selon la revendication 3, dans lequel la tension de départ (Vₛₜₐᵣₜ) est déterminée à partir d'une distribution de tensions de programmation (V_{prog}) d'un échantillon de cellules mémoire, ladite distribution obéissant à une loi normale.

5. Procédé selon l'une des revendications 3 et 4, dans lequel la première probabilité et la deuxième probabilité sont de préférence égales, avantageusement égales à 1/N.

6. Procédé selon l'une quelconque des revendications 3 à 5, comprenant initialement une étape d'étalonnage pour déterminer la tension de départ (Vₛₜₐᵣₜ) et la tension d'arrivée (Vₛₜₒₚ) de la rampe de tension de programmation (40), connaissant le nombre N de cellules mémoire dans ladite au moins une partie de la matrice, ladite étape d'étalonnage comprenant les opérations suivantes :
- fournir une pluralité de cellules mémoire de référence identiques aux cellules mémoire de la matrice ;
- mesurer, pour chaque cellule mémoire de référence, une valeur de tension à laquelle ladite cellule mémoire de référence est programmée ;
- établir une loi de distribution à partir des valeurs de la tension de programmation (V_{prog}) des cellules mémoire de référence ; et
- déterminer, à l'aide de la loi de distribution, la tension d'arrivée (Vₛₜₒₚ) correspondant à la première probabilité et la tension de départ (Vₛₜₐᵣₜ) correspondant à la deuxième probabilité.

7. Procédé selon la revendication 6, dans lequel la valeur de la tension de programmation (V_{prog}) de chaque cellule mémoire de référence est mesurée en appliquant à ladite cellule mémoire de référence une rampe de tension de caractérisation (20), la rampe de tension de caractérisation comportant des paliers de tension (21) successifs, et en mesurant lors des paliers de tension successifs le courant traversant ladite cellule mémoire.

8. Procédé selon l'une quelconque des revendications 1 à 7, dans lequel la rampe de tension de programmation (40) comporte des paliers de tension successifs (41).

9. Procédé de programmation d'une mémoire vive résistive comportant une matrice de cellules mémoire, au moyen d'une rampe de tension de programmation (40) démarrant à une première valeur de tension non-nulle, dite tension de départ (Vₛₜₐᵣₜ), et prenant fin à une deuxième valeur de tension, dite tension d'arrivée (Vₛₜₒₚ), supérieure en valeur absolue à la première valeur de tension, ledit procédé comprenant :
- une étape préliminaire de caractérisation d'une pluralité de cellules mémoire de référence, permettant de mesurer une valeur de tension de programmation (V_{prog}) pour chaque cellule mémoire de référence ;
- une étape d'ajustement statistique des valeurs de tension de programmation (V_{prog}), permettant d'établir une loi de probabilité suivie par les cellules mémoire de la matrice ;
- une étape de détermination d'une valeur de tension de programmation à laquelle un nombre prédéterminé de cellules mémoire de la matrice est programmé, d'après la loi de probabilité ;
- une étape d'application de la rampe de tension de programmation aux cellules mémoire d'une partie au moins de la matrice, la tension d'arrivée de la rampe de programmation étant égale à la valeur de tension de programmation déterminée.

10. Dispositif électronique comprenant des moyens configurés pour mettre en oeuvre le procédé de programmation selon l'une quelconque des revendications 1 à 9, lesdits moyens comprenant une source d'alimentation configurée pour générer la rampe de tension de programmation (40) entre la tension de départ (Vₛₜₐᵣₜ) et la tension d'arrivée (Vₛₜₒₚ) et des moyens pour appliquer la rampe de tension de programmation (40) aux cellules mémoire d'une partie au moins de la matrice.

## Patentansprüche

1. Programmierverfahren eines resistiven Arbeitsspeichers, umfassend eine Matrix aus Speicherzellen, umfassend einen Programmierschritt, bestehend im Anwenden einer Programmier-Spannungsrampe (40) auf die Speicherzellen wenigstens eines Teils der Matrix, wobei die Programmier-Spannungsrampe bei einem ersten Spannungswert ungleich Null, bezeichnet als Ausgangsspannung (Vₛₜₐᵣₜ) beginnt und bei einem zweiten Spannungswert, bezeichnet als Eingangsspannung (Vₛₜₒₚ) endet, deren absoluter Wert höher ist als der erste Spannungswert,
Verfahren, **dadurch gekennzeichnet, dass** die Eingangsspannung (Vₛₜₒₚ) derart bestimmt wird, dass jede Speicherzelle des genannten wenigstens einen Teils der Matrix eine erste Wahrscheinlichkeit aufweist, die zwischen 1/(10N) und 1/N inbegriffen ist, eine Programmierspannung (V_{prog}) mit einem höheren absoluten Wert als die Eingangsspannung (Vₛₜₒₚ) zu haben, wobei N die Anzahl von Speicherzellen in dem genannten wenigstens einen Teil der Matrix ist.

2. Verfahren gemäß Anspruch 1, bei dem die Eingangsspannung (Vₛₜₒₚ) ausgehend von einer Verteilung von Programmierspannungen (V_{prog}) eines Musters von Speicherzellen bestimmt wird, wobei die genannte Verteilung einem normalen Gesetz gehorcht.

3. Verfahren gemäß einem der Ansprüche 1 und 2, bei dem die Ausgangsspannung (Vₛₜₐᵣₜ) derart bestimmt wird, dass jede Speicherzelle des genannten wenigstens einen Teils der Matrix eine zweite Wahrscheinlichkeit aufweist, die zwischen 1/(10N) und 1/N inbegriffen ist, eine Programmierspannung (V_{prog}) mit einem niedrigeren absoluten Wert als die Ausgangsspannung (Vₛₜₐᵣₜ) zu haben.

4. Verfahren gemäß Anspruch 3, bei dem die Ausgangsspannung (Vₛₜₐᵣₜ) ausgehend von einer Verteilung von Programmierspannungen (V_{prog}) eines Musters von Speicherzellen bestimmt wird, wobei die genannte Verteilung einem normalen Gesetz gehorcht.

5. Verfahren gemäß einem der Ansprüche 3 und 4, bei dem die erste Wahrscheinlichkeit und die zweite Wahrscheinlichkeit bevorzugt gleich, vorteilhaft gleich 1/N sind.

6. Verfahren gemäß irgendeinem der Ansprüche 3 bis 5, umfassend anfänglich einen Eichungsschritt zum Bestimmen der Ausgangsspannung (Vₛₜₐᵣₜ) und der Eingangsspannung (Vₛₜₒₚ) der Programmier-Spannungsrampe (40), der die Anzahl N von Speicherzellen in dem genannten wenigstens einen Teil der Matrix kennt, wobei der genannte Eichungsschritt die folgenden Operationen umfasst:
- Liefern einer Vielzahl von Referenz-Speicherzellen, die mit den Speicherzellen der Matrix identisch sind;
- Messen eines Spannungswertes für jede Referenz-Speicherzelle, auf den die genannte Referenz-Speicherzelle programmiert ist;
- Festlegen eines Verteilungsgesetzes ausgehend von den Werten der Programmierspannung (V_{prog}) der Referenz-Speicherzellen; und
- Bestimmen der Eingangsspannung (Vₛₜₒₚ), die der ersten Wahrscheinlichkeit entspricht, und der Ausgangsspannung (Vₛₜₐᵣₜ), die der zweiten Wahrscheinlichkeit entspricht, mithilfe des Verteilungsgesetzes.

7. Verfahren gemäß Anspruch 6, bei dem der Wert der Programmierspannung (V_{prog}) jeder Referenz-Speicherzelle durch Anwenden einer Charakterisierungs-Spannungsrampe (20) auf die genannte Referenz-Speicherzelle gemessen wird, wobei die Charakterisierungs-Spannungsrampe sukzessive Spannungsphasen (21) umfasst, und durch Messen des Stroms, der die genannte Speicherzelle durchquert, in den sukzessiven Spannungsphasen.

8. Verfahren gemäß irgendeinem der Ansprüche 1 bis 7, bei dem die Programmierspannungsrampe (40) sukzessive Spannungsphase (41) umfasst.

9. Programmierverfahren eines resistiven Arbeitsspeichers, umfassend eine Speicherzellen-Matrix, mittels einer Programmier-Spannungsrampe (40), die bei einem ersten Spannungswert ungleich Null, bezeichnet als Ausgangsspannung (Vₛₜₐᵣₜ), beginnt und bei einem zweiten Spannungswert, bezeichnet als Eingangsspannung (Vₛₜₒₚ) endet, deren absoluter Wert höher ist als der erste Spannungswert, wobei das genannte Verfahren umfasst:
- einen einleitenden Charakterisierungsschritt einer Vielzahl von Referenz-Speicherzellen, der das Messen eines Programmier-Spannungswertes (V_{prog}) für jede Referenz-Speicherzelle zulässt;
- einen statistischen Anpassungsschritt der Programmier-Spannungswerte (V_{prog}), die das Festlegen eines Wahrscheinlichkeitsgesetzes zulassen, das von den Speicherzellen der Matrix eingehalten wird;
- einen Bestimmungsschritt eines Programmier-Speicherwertes, auf den eine vorbestimmte Anzahl von Speicherzellen der Matrix programmiert ist, nach dem Wahrscheinlichkeitsgesetz;
- einen Anwendungsschritt der Programmier-Spannungsrampe auf die Speicherzellen wenigstens eines Teils der Matrix, wobei die Eingangsspannung der Programmierrampe gleich dem bestimmten Programmier-Spannungswert ist.

10. Elektronische Vorrichtung, umfassend Mittel, die zum Umsetzen des Programmierverfahrens gemäß irgendeinem der Ansprüche 1 bis 9 konfiguriert sind, wobei die genannten Mittel eine Versorgungsquelle, die zum Erzeugen der Programmier-Spannungsrampe (40) zwischen der Ausgangsspannung (Vₛₜₐᵣₜ) und der Eingangsspannung (Vₛₜₒₚ) konfiguriert ist, und Mittel zum Anwenden der Programmier-Spannungsrampe (40) auf die Speicherzellen wenigstens eines Teils der Matrix umfassen.

## Claims

1. Method for programming a resistive random access memory comprising a matrix of memory cells, comprising a programming step consisting in applying a programming voltage ramp (40) to the memory cells of a part at least of the matrix, the programming voltage ramp starting at a first non-zero voltage value, called start voltage (Vₛₜₐᵣₜ), and ending at a second voltage value, called stop voltage (Vₛₜₒₚ), greater in absolute value than the first voltage value,
method **characterized in that** the stop voltage (Vₛₜₒₚ) is determined such that each memory cell of said at least one part of the matrix has a first probability comprised between 1/(10N) and 1/N of having a programming voltage (V_{prog}) greater in absolute value than the stop voltage (Vₛₜₒₚ), N being the number of memory cells in said at least one part of the matrix.

2. Method according to claim 1, wherein the stop voltage (Vₛₜₒₚ) is determined from a distribution of programming voltages (V_{prog}) of a sample of memory cells, said distribution obeying a normal law.

3. Method according to one of claims 1 and 2, wherein the start voltage (Vₛₜₐᵣₜ) is determined such that each memory cell of said at least one part of the matrix has a second probability comprised between 1/(10N) and 1/N of having a programming voltage (V_{prog}) less in absolute value than the start voltage (Vₛₜₐᵣₜ).

4. Method according to claim 3, wherein the start voltage (Vₛₜₐᵣₜ) is determined from a distribution of programming voltages (V_{prog}) of a sample of memory cells, said distribution obeying a normal law.

5. Method according to one of claims 3 and 4, wherein the first probability and the second probability are preferably equal, advantageously equal to 1/N.

6. Method according to any of claims 3 to 5, initially comprising a calibration step to determine the start voltage (Vₛₜₐᵣₜ) and the stop voltage (Vₛₜₒₚ) of the programming voltage ramp (40), knowing the number N of memory cells in said at least one part of the matrix, said calibration step comprising the following operations:
- providing a plurality of reference memory cells identical to the memory cells of the matrix;
- measuring, for each reference memory cell, a voltage value at which said reference memory cell is programmed;
- establishing a distribution law from the programming voltage values (V_{prog}) of the reference memory cells; and
- determining, using the distribution law, the stop voltage (Vₛₜₒₚ) corresponding to the first probability and the start voltage (Vₛₜₐᵣₜ) corresponding to the second probability.

7. Method according to claim 6, wherein the programming voltage value (V_{prog}) of each reference memory cell is measured by applying to said reference memory cell a characterization voltage ramp (20), the characterization voltage ramp comprising successive voltage stages (21), and by measuring during successive voltage stages the current passing through said memory cell.

8. Method according to any of claims 1 to 7, wherein the programming voltage ramp (40) comprises successive voltage stages (41).

9. Method for programming a resistive random access memory comprising a matrix of memory cells, by means of a programming voltage ramp (40) starting at a first non-zero voltage value, called start voltage (Vₛₜₐᵣₜ), and ending at a second voltage value, called stop voltage (Vₛₜₒₚ), greater in absolute value than the first voltage value, said method comprising:
- a preliminary step of characterization of a plurality of reference memory cells, making it possible to measure a programming voltage value (V_{prog}) for each reference memory cell;
- a step of statistical adjustment of the programming voltage values (V_{prog}), making it possible to establish a probability law followed by the memory cells of the matrix;
- a step of determining a programming voltage value at which a predetermined number of memory cells of the matrix is programmed, according to the probability law;
- a step of applying the programming voltage ramp to the memory cells of a part at least of the matrix, the stop voltage of the programming voltage ramp being equal to the determined programming voltage value.

10. Electronic device comprising means configured to implement the programming method according to any of claims 1 to 9, said means comprising a supply source configured to generate the programming voltage ramp (40) between the start voltage (Vₛₜₐᵣₜ) and the stop voltage (Vₛₜₒₚ) and means for applying the programming voltage ramp (40) to the memory cells of a part at least of the matrix.
